# EUROPEAN PATENT APPLICATION

(11) **EP 1 367 875 A1**
(43) Date of publication of application: **03.12.2003**
(21) Application number: 02711221.8
(22) Date of filing: 24.01.2002
(51) Int. Cl.: H05K 3/34

(54) **LAND PORTION OF PRINTED WIRING BOARD, METHOD FOR MANUFACTURING PRINTED WIRING BOARD, AND PRINTED WIRING BOARD MOUNTING METHOD**

(30) Priority: 07.03.2001 JP 2001063366
(71) Applicant: Sony Corporation, Tokyo 141-0001 (JP)
(72) Inventor: ITOU, Kazuhiro, Kosai-shi, Shizuoka 431-0496 (JP); NAGATA, Mamoru, Shinagawa-ku, Tokyo 141-0001 (JP); KAYABA, Masao, Shinagawa-ku, Tokyo 141-0001 (JP); MIYAKE, Yoshihiko, Shinagawa-ku, Tokyo 141-0001 (JP); ARAKANE, Hideyuki, Shinagawa-ku, Tokyo 141-0001 (JP)
(74) Representative: Müller, Frithjof E., Dipl.-Ing.
(86) International application number: JP0200495
(87) International publication number: WO02071819

(57) **Abstract**

A circumferential portion of a land portion 14 which is formed on a surface of the printed wiring board for mounting a component with a lead-free solder is covered with an extending portion 21 of a solder mask 20 formed on the surface of the printed wiring board.

## Description

### TECHNICAL FIELD

The present invention relates to a land portion of a printed wiring board, a method of manufacturing a printed wiring board, and a component mounting method for a printed wiring board. More specifically, it relates to a land portion of a printed wiring board and a method of manufacturing a printed wiring board for applying a lead-free solder (non-lead solder), and to a component mounting method for a printed wiring board, to which a lead-free solder is applied.

### BACKGROUND ART

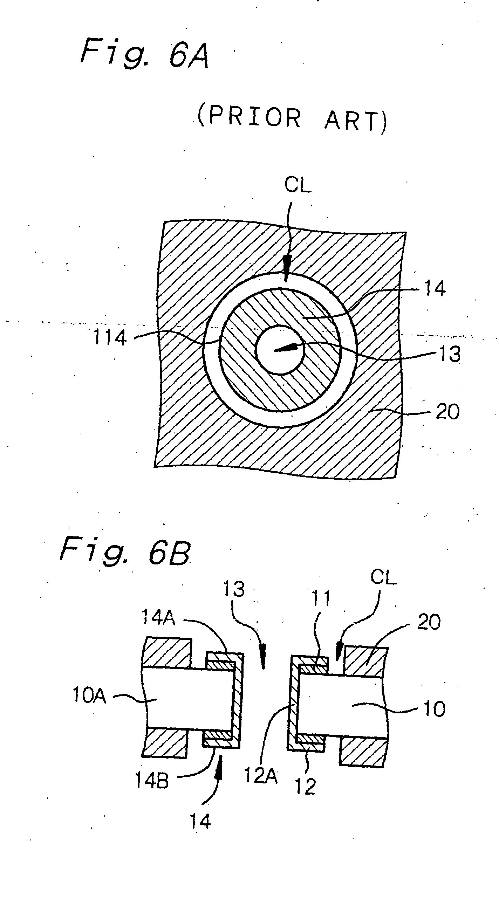

Conventionally, the outermost surface of a printed wiring board excluding a land portion and a connecting portion is covered with a solder mask. A schematic partial plan view of Fig. 6A and a partial end view of Fig. 6B schematically show a positional relationship between the land portion and the solder mask. A printed wiring board can be manufactured, for example, by the steps of boring a hole in a base material for printed wirings 10, which base material is a glass-fabric base/epoxy resin copper-clad laminate with copper foils 11 on double sides, forming a through-hole portion 13 by through-hole plating, forming wirings (not shown) and land portions 14 (14A, 14B) by etching a plated layer 12 and the copper foils 11, and forming a solder mask 20. For clearly showing the land portion 14 and the solder mask 20, in Fig. 6A, slanting lines tilting downward from left to right are provided on the land portion 14, and slanting lines tilting downward from right to left are provided on the solder mask 20.

As shown in Figs. 6A and 6B, generally, a circumferential portion of the land portion 14 is not covered with the solder mask 20 formed on the surface of the printed wiring board. A clearance CL is present between an outer edge 114 of the land portion 14 and an end portion of the solder mask 20. It is defined, for example, according to JIS C 5013 (1990), chapter 6.4.5 that the above clearance CL as a minimum clearance is 200 µm in class I, 100 µm in class II, or 50 µm in class III.

As a solder for soldering a printed wiring board, conventionally, a tin-lead (Sn-Pb) eutectic solder is used. Lead in the solder works to decrease the melting point of the solder, works to promote the fluidity thereof and works to decrease the surface tension thereof. With regard to the toxicity of lead, however, its influence on human bodies has been a concern for a long time. Further, environmental pollutions caused by lead are also problems. In recent years, therefore, lead-free solders (non-lead solder) are developed and used increasingly. A leas-free solder is composed, for example, of 93 to 98 % by weight of tin and a balance of silver, copper and antimony, and some lead-free solders contain small amounts of bismuth, cadmium, nickel, sulfur, arsenic and zinc. Such lead-free solders have a melting temperature of 210 to 230°C, which is higher than the melting temperature (approximately 183°C) of a tin-lead eutectic solder.

When a component-lead-portion 40 as a component-attaching portion is soldered to the through-hole portion 13 shown in Figs. 6A and 6B, the component-lead-portion 40 is inserted into the through-hole portion 13 from a component side, a top portion of the component-lead-portion 40 exposed on a solder side opposite to the component side is soldered to a land portion 14B on the solder side with a solder such that a fillet 31 is formed. The solder penetrates and fills a gap between the through-hole portion 13 and the component-lead-portion 40, and the solder that passes through the through-hole portion 13 forms the fillet on the land 14A on the component side. In this manner, a part of the component-lead-portion 40 on the component side is soldered to the land portion 14A.

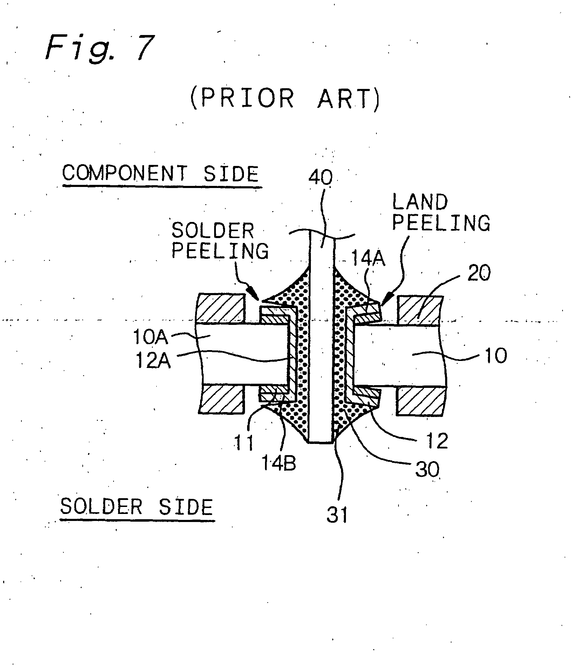

When such a lead-free solder having a high melting temperature is used for component mounting, as shown in a schematic partial end view of Fig. 7, a lift-off (solder peeling) phenomenon takes place in which the fillet 31 of a lead-free solder 30 peels from the land portion 14, or a land peeling phenomenon takes place in which the land portion 14 peels from the surface of a base material 10A constituting the material for printed wirings 10. Fig. 7 schematically shows a state where the lift-off (solder peeling) phenomenon takes place on the left side of the land portion, and Fig. 7 also schematically shows a state where the land peeling phenomenon takes place on the right side of the land portion. Further, sometimes, there occurs a phenomenon in which the lead-free solder 30 peels from the surface of the component-lead-portion 40 of the component, or there occurs a phenomenon in which a plated layer 12A (see Fig. 6B) formed on an inner wall of the through-hole portion 13 peels from an inner wall of the base material 10A. Particularly, the occurrence of the land peeling phenomenon and the peeling of the plated layer 12A are vital defects for a printed wiring board after component mounting.

The lift-off phenomenon and the land peeling phenomenon do not frequently take place when a conventional leaded solder is used. These phenomena frequently take place when a lead-free solder is used. Whatever method the soldering method is, that is, regardless of whether it is a flow soldering method or a soldering iron method, the above phenomena take place. Further, no correlation is observed between any site where the above phenomena take place and any soldering method. When a soldering iron is used to remove a component from a land portion, the above phenomena sometimes take place. It is assumed that the above phenomena are caused by the heat shrinkage or coagulation shrinkage of a lead-free solder. However, no proper means have been established for inhibiting or preventing these phenomena.

It is therefore an object of the present invention to provide a land portion of a printed wiring board, a method of manufacturing a printed wiring board and a component mounting method for a printed wiring board, in which the occurrence of the lift-off phenomenon and the land peeling phenomenon can be inhibited or prevented even when a lead-free solder (non-lead solder) having a high melting temperature is used for component mounting.

### DISCLOSURE OF THE INVENTION

The land portion of a printed wiring board according to a first aspect of the present invention for achieving the above object is a land portion formed on a surface of a printed wiring board for mounting a component with a lead-free solder,
wherein a circumferential portion of said land portion is covered with an extending portion of a solder mask formed on the surface of the printed wiring board, and
the circumferential portion of said land portion is covered with the extending portion of the solder mask, such that the circumferential portion has a covered area that is at least 5 x 10⁻⁵ m wide from the outer edge of the land portion.

In the land portion of a printed wiring board according to the first aspect of the present invention, or in a method of manufacturing a printed wiring board or a compound mounting method for a printed wiring board according to the first aspect of the present invention to be described later, since the circumferential portion of the land portion is covered with the extending portion of the solder mask such that the circumferential portion has a covered area that is at least 5 x 10⁻⁵ m wide from the outer edge of the land portion, the occurrence of the lift-off (solder peeling) phenomenon and the land peeling phenomenon can be suppressed or prevented, even if the fluctuation in the steps of forming the land portion and forming the solder mask is taken account of. Particularly, the land peeling phenomenon caused by manually attaching and removing a component with a soldering iron, etc., can be reliably suppressed or prevented. The area of the land portion that area is not covered with the extending portion of the solder mask can be determined as required so long as component mounting can be reliably carried out, and the above area of the land portion can be determined depending upon the size and form of a component that is to be mounted on the land portion. The area of the land portion that is not covered can be similarly determined in the method of manufacturing a printed wiring board according to the first aspect of the present invention and the component mounting method for a printed wiring board according to the first aspect of the present invention.

The land portions of a printed wiring board according to a second aspect of the present invention for achieving the above object are land portions extending on a component side and on a solder side of a printed wiring board from a through-hole portion made through the printed wiring board, for mounting a component with a lead-free solder,
wherein a circumferential portion of the land portion extending on the component side is covered with an extending portion of a solder mask formed on the component side of the printed wiring board, and
the circumferential portion of the land portion extending on the component side is covered with an extending portion of the solder mask formed on the component side of the printed wiring board, such that the circumferential portion has a covered area that is at least 5 x 10⁻⁵ m wide from the outer edge of the land portion.

In the land portion of a printed wiring board according to the second aspect of the present invention or in a method of manufacturing a printed wiring board or a component mounting method for a printed wiring board according to a second aspect of the present invention to be described later, since the circumferential portion of the land portion extending on the component side is covered with the extending portion of the solder mask formed on the component side of the printed wiring board such that the circumferential portion has a covered area that is at least 5 x 10⁻⁵ m wide from the outer edge of the land portion, the occurrence of the lift-off (solder peeling) phenomenon and the land peeling phenomenon can be suppressed or prevented, even if the fluctuation in the steps of forming the land portion and forming the solder mask is taken account of. The area of the land portion that area is not covered with the extending portion of the solder mask can be determined as required so long as component mounting can be reliably carried out, and the above area of the land portion can be determined depending upon the size and form of a component that is to be mounted on the land portion. Almost the entire land portion extending on the component side may be sometimes covered with the extending portion of the solder mask. That is, there may be formed a state where the through-hole portion alone is exposed. The. above constitution can be also employed in the method of manufacturing a printed wiring board according to second and third aspects of the present invention or in the component mounting method for a printed wiring board according to second and third aspects of the present invention to be described later.

Like the land portion of a printed wiring board according to the second aspect of the present invention, the circumferential portion of the land portion extending on the solder side may not be covered with the solder mask formed on the solder side of the printed wiring board. However, for suppressing or preventing the occurrence of the lift-off phenomenon and the land peeling phenomenon, it is preferred that the circumferential portion of the land portion extending on the solder side is covered with an extending portion of the solder mask formed on the solder side of the printed wiring board.

That is, the land portions of a printed wiring board according to a third aspect of the present invention for achieving the above object are land portions extending on a component side and on a solder side of a printed wiring board from a through-hole portion made through the printed wiring board for mounting a component with a lead-free solder,
wherein a circumferential portion of the land portion extending on the component side is covered with an extending portion of a solder mask formed on the component side of the printed wiring board, and
a circumferential portion of the land portion extending on the solder side is covered with an extending portion of the solder mask formed on the solder side of the printed wiring board.

In the land portion of a printed wiring board according to the third aspect,'when the fluctuation in the steps of forming the land portion and forming the solder mask is taken account of, and for more reliably suppressing or preventing the lift-off phenomenon and the land peeling phenomenon, desirably, the circumferential portion of the land portion extending on the component side is covered with the extending portion of the solder mask formed on the component side such that the circumferential portion has a covered area that is at least 5 x 10⁻⁵ m wide from the outer edge of the land portion, and desirably, the circumferential portion of the land portion extending on the solder side is covered with the extending portion of the solder mask formed on the solder side of the printed wiring board such that the circumferential portion has a covered area that is at least 5 x 10⁻⁵ m wide from the outer edge of the land portion. Further, desirably, the area of the land portion extending on the component side, which area is not covered with the extending portion of the solder mask, is smaller than the area of the land portion extending on the solder side, which area is not covered with the extending portion of the solder mask. In this manner, a component can be more reliably mounted on (fixed to) the land portion.

The method of manufacturing a printed wiring board according to a first aspect of the present invention for achieving the above object comprises the steps of;
(A) forming a wiring and a land portion on a surface of a base material for printed wirings, and
(B) forming a solder mask on the surface of the base material for printed wirings, to obtain a printed wiring board,
wherein the step (B) includes the step of covering a circumferential portion of the land portion with an extending portion of the solder mask-formed on the base material for printed wirings, such that the circumferential portion has a covered area that is at least 5 x 10⁻⁵ m wide from the outer edge of the land portion.

The component mounting method for a printed wiring board according to a first aspect of the present invention for achieving the above object comprises the steps of;
(A) forming a wiring and a land portion on a surface of a base material for printed wirings,
(B) forming a solder mask on the surface of the base material for printed wirings, to obtain a printed wiring board, and
(C) fixing a component-attaching portion to the land portion with a lead-free solder, to mount a component on the printed wiring board,
wherein the step (B) includes the step of covering a circumferential portion of the land portion with an extending portion of the solder mask formed on the base material for printed wirings, such that the circumferential portion has a covered area that is at least 5 x 10⁻⁵ m wide from the outer edge of the land portion.

The method of manufacturing a printed wiring board according to a second aspect of the present invention for achieving the above object comprises the steps of;
(A) forming a through-hole portion through a base material for printed wirings, and forming land portions extending on a component side and on a solder side of the base material for printed wirings from said through-hole portion, and a wiring on the base material for printed wirings, and
(B) forming a solder mask on the component side and the solder side of the base material for printed wirings, to obtain a printed wiring board,
wherein the step (B) includes the step of covering a circumferential portion of the land portion extending on the component side with an extending portion of the solder mask formed on the component side of the base material for printed wirings, such that the circumferential portion has a covered area that is at least 5 x 10⁻⁵ m wide from the outer edge of the land portion.

The component mounting method for a printed wiring board according to the second aspect of the present invention for achieving the above object comprises the steps of;
(A) forming a through-hole portion through a base material for printed wirings, and forming land portions extending on a component side and on a solder side of the base material for printed wirings from said through-hole portion, and a wiring on the base material for printed wirings,
(B) forming a solder mask on the component side and the solder side of the base material for printed wirings, to obtain a printed wiring board, and
(C) inserting a component-attaching portion into the through-hole portion and fixing the component-attaching portion to the through-hole portion and the land portion with a lead-free solder, to mount a component on the printed wiring board,
wherein the step (B) includes the step of covering a circumferential portion of the land portion extending on the component side with an extending portion of the solder mask formed on the component side of the base material for printed wirings, such that the circumferential portion has a covered area that is at least 5 x 10⁻⁵ m wide from the outer edge of the land portion.

Like the method of manufacturing a printed wiring board or the component mounting method for a printed wiring board according to the second aspect of the present invention, the circumferential portion of the land portion extending on the solder side may not be covered with the solder mask formed on the solder side of the printed wiring board in the above step (B). However, for suppressing or preventing the occurrence of the lift-off phenomenon and the land peeling phenomenon, it is preferred that the circumferential portion of the land portion extending on the solder side is covered with an extending portion of the solder mask formed on the solder side of the printed wiring board.

That is, the method of manufacturing a printed wiring board according to the third aspect of the present invention for achieving the above object comprises the steps of;
(A) forming a through-hole portion through a base material for printed wirings, and forming land portions extending on a component side and on a solder side of the base material for printed wirings from said through-hole portion, and a wiring on the base material for printed wirings, and
(B) forming a solder mask on the component side and the solder side of the base material for printed wirings, to obtain a printed wiring board,
wherein the step (B) includes the step of covering a circumferential portion of the land portion extending on the component side with an extending portion of the solder mask formed on the component side of the base material for printed wirings and the step of covering a circumferential portion of the land portion extending on the solder side with an extending portion of the solder mask formed on the solder side of the printed wiring board.

The component mounting method for a printed wiring board according to the third aspect of the present invention for achieving the above object comprises the steps of;
(A) forming a through-hole portion through a base material for printed wirings, and forming land portions extending on a component side and on a solder side of the base material for printed wirings from said through-hole portion, and a wiring on the base material for printed wirings,
(B) forming a solder mask on the component side and the solder side of the base material for printed wirings, to obtain a printed wiring board, and
(C) inserting a component-attaching portion into the through-hole portion and fixing the component-attaching portion to the through-hole portion and the land portion with a lead-free solder, to mount a component on the printed wiring board,
wherein the step (B) includes the step of covering a circumferential portion of the land portion extending on the component side with an extending portion of the solder mask formed on the component side of the base material for printed wirings and the step of covering a circumferential portion of the land portion extending on the solder side with an extending portion of the solder mask formed on the solder side of the printed wiring board.

In the method of manufacturing a printed wiring board according to the third aspect of the present invention or in the component mounting method for a printed wiring board according to the third aspect of the present invention, when the fluctuation in the steps of forming the land portion and forming the solder mask is taken account of, and for more reliably suppressing or preventing the lift-off phenomenon and the land peeling phenomenon, more desirably, the circumferential portion of the land portion extending on the component side is covered with the extending portion of the solder mask formed on the component side of the printed wiring board such that the circumferential portion has a covered area that is at least 5 x 10⁻⁵ m wide from the outer edge of the land portion, and the circumferential portion of the land portion extending on the solder side is covered with the extending portion of the solder mask formed on the solder side of the printed wiring board such that the circumferential portion has a covered area that is at least 5 x 10⁻⁵ m wide from the outer edge of the land portion, in the above step (B). Further, desirably, the area of the land portion extending on the component side, which area is not covered with the extending portion of the solder mask, is smaller than the area of the land portion extending on the solder side, which area is not covered with the extending portion of the solder mask. In this manner, a component can be more reliably mounted on (fixed to) the land portion.

In the land portion of a printed wiring board, the method of manufacturing a printed wiring board or the component mounting method for a printed wiring board according to any one of the first to third aspects of the present invention (these will be sometimes generally referred to as "the present invention" hereinafter), the size of the land portion and the diameter of the through-hole portion are essentially any size and any diameter determined as required, and can be determined as required depending upon the specification required of a printed wiring board, dimensions of a component to be mounted and the like. Further, the plan form of the land portion is also essentially any form, and can be selected from a circle, an oval, rectangles including a regular square and an oblong, a roundish rectangle, a polygon or a roundish polygon. When the land portion has a circular plan form, preferably, the form of outer edge of the land portion and the form of edge portion of the extending portion of the solder mask covering the land portion are substantially similar (analogous) to each other. That is, although being varied depending upon the accuracy of forming the solder mask, desirably, the distance from the outer edge of the land portion to the edge portion of the extending portion of the solder mask covering the land portion is substantially equal regardless of a position of the outer edge of the land portion. When the land portion has a plan form that is other than a circle, preferably, the form of the edge portion of the extending portion of the solder mask covering the land portion is circular. That is, although being varied depending upon the accuracy of forming the solder mask, desirably, the distance from the outer edge of the land portion to the edge portion of the extending portion of the solder mask covering the land portion is kept being, for example, 5 x 10⁻⁵ m as a minimum value regardless of a position of the outer edge of the land portion. In many cases, one or a plurality of wirings extend(s) from the land portion. The width and thickness of the wiring can be determined on the basis of specifications required of a printed wiring board as well.

In the present invention, essentially, the lead-free solder (non-lead solder) may have any composition and properties. For example, a lead-free solder containing 93 to 98% by weight of tin (Sn) and a balance of silver (Ag), copper (Cu) or antimony (Sb) and such a lead-free solder further containing a very small amount of bismuth (Bi), cadmium (Cd), nickel (Ni), sulfur (S), arsenic (As), zinc (Zn), cobalt (Co), phosphorus (P) or indium (In) may be used. Examples of the lead-free solder include Sn-Bi, Sn-Bi-Ag-Cu, Sn-Zn, Sn-Zn-In, Sn-Ag-Zn, Sn-Ag, Sn-Ag-Cu, Sn-Ag-Bi-Cu and Sn-Cu. Lead-free cream solder (solder paste) containing the above components may be used depending upon a component to be mounted, a component mounting method or a soldering method.

The solder mask (also called "solder resist") in the present invention includes a thermosetting resin film, an ultraviolet-curable resin film, a photosensitive resin film and a so-called dry film. When the solder mask is composed of a thermosetting resin film, the thermosetting resin is printed on the surface (the component side, solder side) of the base material for printed wirings by a screen printing method, and the printed resin is heat-treated. When the solder mask is composed of an ultraviolet-curable resin film, the ultraviolet-curable resin is printed on the surface (the component side, solder side) of the base material for printed wirings by a screen printing method, and the printed resin is exposed to ultraviolet ray, which may be followed by further heat treatment as required. When the solder mask is composed of a photosensitive resin film, a photosensitive resin layer is formed on the surface (the component side, solder side) of the base material for printed wirings by a screen printing method, a spray method, a curtain coating method, a spin coating method or the like, and the photosensitive resin layer is exposed, developed and cured. When the solder mask is composed of a dry film, the dry film is laminated on the surface (the component side, solder side) of the base material for printed wirings, and the dry film is exposed, developed and cured. A film having an adhesive layer may be used. In this case, the film is bored in a portion corresponding to the land portion by drilling, punching, laser application or the like, and the film is laminated on the surface (the component side, solder side) of the base material for printed wirings and then cured.

The printed wiring board in the present invention includes a rigid printed wiring board having wirings formed on a single side or double sides, a multi-layered rigid printed wiring board, a multi-layered flex rigid printed wiring board, a metal-core printed wiring board having wirings formed on a single side or double sides, a multi-layered metal-core printed wiring board, a metal-base printed wiring board having wirings formed on a single side or double sides, a multi-layered metal-base printed wiring board, a buildup multi-layered printed wiring board and a ceramic wring board. The method of manufacturing the above various printed wiring boards can be selected from conventional methods. The method of forming the land portion, the wiring and the through-hole portion can be selected from so-called subtractive methods such as a panel plating method and a pattern plating method or so-called additive methods such as a semi-additive method and a full-additive method. The base material for constituting the base material for printed wirings essentially can have any constitution. Examples of the base material constitution include combinations such as paper/phenolic resin, paper/epoxy resin, glass cloth/epoxy resin, glass non-woven fabric/epoxy resin, glass cloth/glass non-woven fabric/epoxy resin, synthetic fiber/epoxy resin, glass cloth/polyimide resin, glass cloth/modified polyimide resin, glass cloth/epoxy-modified polyimide resin, glass cloth/bismaleimide/triazine/epoxy resin, glass cloth/fluorine-containing resin, glass cloth/PPO (polyphenylene oxide) resin, and glass cloth/EPE (polyphenylene ether) resin. The wirings (circuits) and the land portion are formed, for example, by etching a copper foil (or a copper foil plated with a copper). The thickness of the copper foil can be determined on the basis of specifications required of the wirings and the land portions. For example, the wirings and the land portion are 70 µm thick, 35 µm thick, 18 µm thick, 12 µm thick or 9 µm thick. The thickness of the plated layer can be determined on the basis of specifications required of the printed wiring board as well.

In the land portion of a printed wiring board, the method of manufacturing a printed wiring board or the component mounting method for a printed wiring board according to the first aspect of the present invention, the component includes chip components such as various angular or cylindrical resistance chips, SO-packaged resistance net works, various condenser chips, various inductor chips, various device components (for example, a chip-type semi-fixed volume and a chip-type light-touch switch) and special-function components (for example, a chip-type varistor, a chip-type surface-wave filter, a chip-type ceramic oscillator and a chip-type EMI filter); and IC components typified by LCC (Leadless Chip Carrier), PLCC(Plastic Leaded Chip Carrier), SOP(Small Outline Package) and QFP(Quad Flat Package). These components will be referred to as "surface-mounting component" for convenience.

In the land portion of a printed wiring board, the method of manufacturing a printed wiring board or the component mounting method for a printed wiring board according to the second or third aspect of the present invention, the component includes axial lead components such as a carbon-coated resistor, a cylindrical ceramic condenser and a diode; radial lead components such as a ceramic condenser, an aluminum electrolytic condenser and a transistor; IC components typified by SIP (Single Inline Package) and DIP (Dual Inline Package) and PGA(Pin Grid Array); and various connectors. These components will be referred to as "lead-portion-attached components" for convenience.

In the land portion of a printed wiring board, the method of manufacturing a printed wiring board or the component mounting method for a printed wiring board according to any one of the first to third aspects of the present invention, specific methods of mounting a component with a lead-free solder include a soldering iron method; various dip-soldering methods; flow soldering methods of various types such as a wave method, a double wave method, a flow dipping method, a single-flow method, a magnetic method, an inert gas atmosphere application method, a plasma method and an ultrasonic jet flow method; and re-flow soldering methods of various types such as infra-red heating method, a hot air heating method, a saturated steam heating method, a hot plate heating method, a laser heating method, a liquid heating method and an inert gas atmosphere application method.

Component mounting on a printed wiring board includes various cases such as a case where a surface-mounting component is mounted on one surface of a printed wiring board, a case where surface-mounting components are mounted on both surfaces of a printed wiring board, a case where a lead-portion-attached component is mounted on one surface of a printed wiring board, a case where a surface-mounting component and a lead-portion-attached component are mounted on one surface of a printed wiring board, and a case where surface-mounting components are mounted on both surfaces and a lead-portion-attached component is mounted on one of the surfaces of a printed wiring board. In each of these cases, the land portion of a printed wiring board, the method of manufacturing a printed wiring board or the component mounting method for a printed wiring board according to any one of the first to third aspects of the present invention can be employed as required. In many case, the land portions for a printed wiring board according to the' first to third aspects of the present invention can exist together in one printed wiring board, and in many cases, the methods of manufacturing a printed wiring board or the component mounting methods for a printed wiring board according to the first to third aspects of the present invention can be applied to one printed wiring board together.

In the land portion of a printed wiring board, the method of manufacturing a printed wiring board or the component mounting method for a printed wiring board according to the first aspect of the present invention, since the circumferential portion of the land portion is covered with the extending portion of the solder mask formed on the surface of the printed wiring board, the occurrence of the land peeling phenomenon can be reliably suppressed or prevented. Further, in the land portion of a printed wiring board, the method of manufacturing a printed wiring board or the component mounting method for a printed wiring board according to the second or third aspect of the present invention, since the circumferential portion of the land portion extending on the component side is covered with the extending portion of the solder mask formed on the component side of the printed wiring board, the volume of a fillet can be decreased. As a result, the stress during the coagulation of the solder can be decreased, and the occurrence of the lift-off phenomenon and the land peeling phenomenon can be reliably suppressed or prevented. Further, when the circumferential portion of the land portion extending on the solder side is'covered with the extending portion of the solder mask formed on the solder side of the printed wiring board, the occurrence of the lift-off phenomenon and the land peeling phenomenon can be more reliably suppressed or prevented.

### BRIEF DESCRIPTION OF DRAWINGS

The present invention will be explained based on Examples with reference to drawings hereinafter.
Figs. 1A and 1B are a schematic partial plan view and a schematic partial end view showing a positional relationship between a land portion and a solder mask in a printed wiring board of Example 1, respectively.
Figs. 2A and 2B are a schematic partial plan view and a schematic partial end view showing a positional relationship between a land portion and a solder mask in a printed wiring board of Example 2, respectively.
Fig. 3 is a schematic partial end view showing a state where a component is mounted on land portions in Example 2.
Fig. 4 is a schematic partial end view showing a positional relationship between a land portion and a solder mask in a printed wiring board of Example 4.
Figs. 5A and 5B are a schematic partial plan view and a schematic partial end view showing a positional relationship between a land portion and a solder mask in a variant of the printed wiring board of Example 2, respectively.
Figs. 6A and 6B are a schematic partial plan view and a schematic partial end view showing a positional relationship between a land portion and a solder mask in a conventional printed wiring board, respectively.
Fig. 7 is a schematic partial end view of a conventional printed wiring board for explaining problems caused when a lead-free solder is used in the printed wiring board.

### BEST MODE FOR CARRYING OUT THE INVENTION

### Example 1

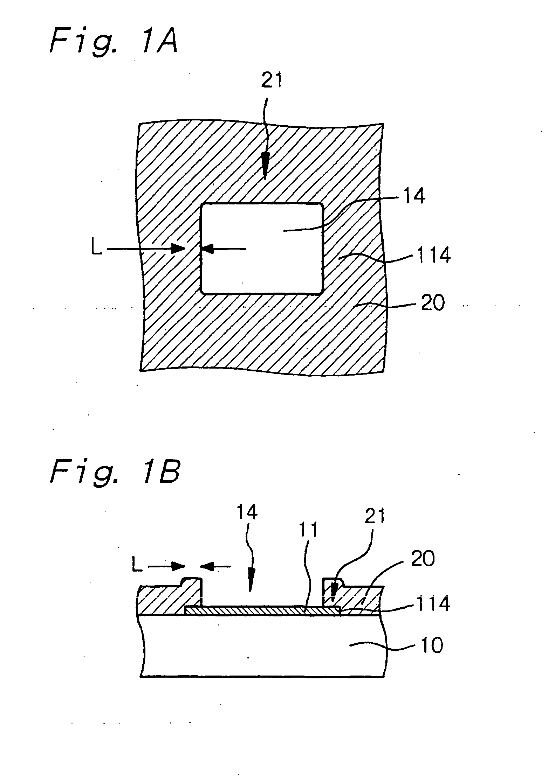

Example 1 is concerned with a land portion of a printed wiring board, a method of manufacturing a printed wiring board and a component mounting method for a printed wiring board according to the first aspect of the present invention. A positional relationship between a land portion and a solder mask is schematically shown in the partial plan view of Fig. 1A and the partial end view of Fig. 1B. The printed wiring board in Example 1 is manufactured, for example, by known steps of providing a base material for printed wirings 10 that is a glass-fabric base/epoxy resin copper-clad laminate (thickness 1.0 mm) with a copper foil (thickness 18 µm) 11 on a single side, etching the copper foil 11 to form wirings (not shown) and a land portion 14, and forming a solder mask 20 made of a ultraviolet-curable resin coating. The wiring extends from the land portion. For clearly showing the solder mask 20 in Fig. 1A, slanting lines tilting downward from right to left are provided on the solder mask 20. The reference numeral 114 shows an outer edge of the land portion 14.

The above land portion 14 is formed on the surface of the printed wiring board for mounting a component with a lead-free solder. In Example 1, the land portion 14 has a plan form that is a 0.9 mm x 1.4 mm oblong. The circumferential portion of the land portion 14 is covered with an extending portion 21 of the solder mask 20 formed on the surface of the printed wiring board. In this case, the circumferential portion of the land portion is covered with the extending portion 21 of the solder mask 20, such that the circumferential portion has a covered area that is at least 5 x 10⁻⁵ m wide, or an average of 75 µm (= L) wide in Example 1, from the outer edge 114 of the land portion 14. That is, in Example 1, the edge portion of the extending portion 21 of the solder mask 20, which extending portion is covering the land portion 14, has a form that is a 0.75 mm x 1.25 mm oblong.

In Example 1, a lead-free cream solder (solder paste) containing Sn-Ag-Cu as a main component and a lead-free cream solder containing An-Ag-Bi-Cu as a main component were used, and a component-attaching portion of a surface-mounting component having an Sn-10Pb plated layer formed thereon was fixed to the land portion 14 with the above lead-free cream solder according to a hot air heating reflow soldering method, whereby the component was mounted on the printed wiring board. Then, the component was removed with a blower and with a soldering iron to study whether or not a land peeling phenomenon took place.

As Comparative Example 1, a printed wiring board was manufactured in the same manner as in Example 1 except that a clearance CL of an average of 75 µm was provided between the outer edge 114 of the land portion 14 and the end portion of the solder mask 20. A component was mounted on such a land portion in the same manner as in Example 1.

After component mounting, it was studied whether or not a lift-off phenomenon and a land peeling phenomenon took place on each of the land portions of the printed wiring boards. Specifically, the wirings extending from the land portions were inspected for breaking of wire caused by the above phenomena. A printed wiring board having breaking of wire even at one portion was taken as being defective. In Example 1, no printed wiring board had breaking of wire. In Comparative Example 1, approximately 10 % of the printed wiring boards had breaking of wire although such percentages differed depending upon skills of workers. The above results show that the occurrence of the lift-off phenomenon and the land peeling phenomenon can be remarkably prevented by employing the land portion of a printed wiring board, the method of manufacturing a printed wiring board and component mounting method for a printed wiring board according to the first aspect of the present invention.

### Example 2

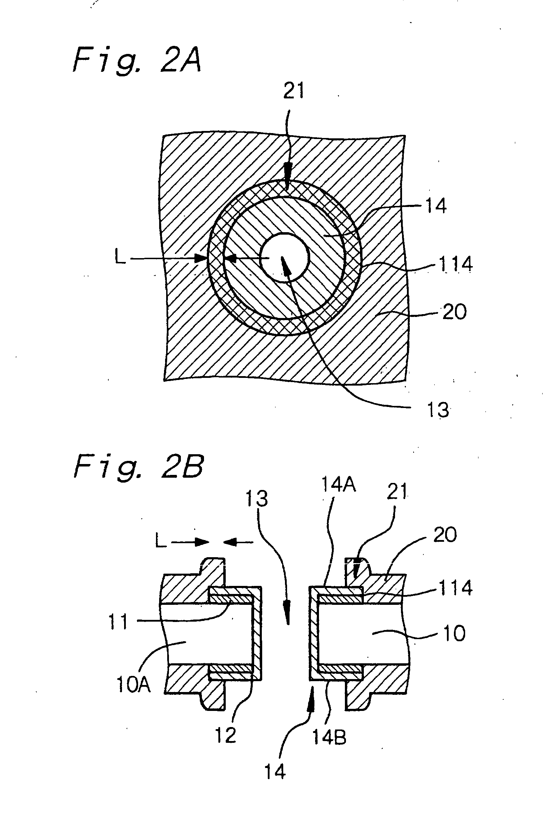

Example 2 is concerned with a land portion of a printed wiring board, a method of manufacturing a printed wiring board and a component mounting method for a printed wiring board according to the second and third aspects of the present invention. A positional relationship between a land portion and a solder mask is schematically shown in the partial plan view of Fig. 2A and the partial end view of Fig. 2B. The printed wiring board in Example 2 is manufactured, for example, by known steps of providing a base material for printed wirings 10 that is a glass-fabric base/epoxy resin copper-clad laminate (FR-4, thickness 1.6 mm) with copper foils (thickness 18 µm) 11 on double sides, boring the base material for printed wirings 10, forming a through-hole portion (diameter 0.8 mm) 13 by through-hole plating, etching a plate layer 12 and the copper foils 11 to form wirings (not shown) and land portions 14 (14A, 14B), and forming a solder mask 20. For clearly showing the land portion 14 and the solder mask 20 in Fig. 2A, slanting lines tilting downward from left to right are provided on the land portion 14, and slanting lines tilting downward from right to left are provided on the solder mask 20. The reference numeral 114 shows an outer edge of the land portion 14.

The above land portions 14 (14A, 14B) extend from the through-hole portion 13 made in the printed wiring board for mounting a component with a lead-free solder, on a component side and on a solder side of the printed wiring board. In Example 2, a circumferential portion of the land portion 14A extending on the component side is covered with an extending portion 21 of the solder mask 20 formed on the component side of the printed wiring board, and a circumferential portion of the land portion 14B extending on the solder side is covered with an extending portion 21 of the solder mask 20 formed on the solder side of the printed wiring board.

In Example 2, the land portions 14A and 14B have a plan form that is a circle having a diameter of 1.35 mm. In this case, the circumferential portions of the land portions 14A and 14B are covered with the extending portions 21 of the solder mask 20 formed on the component side and on the solder side of the printed wiring board, such that each of the circumferential portions has a covered area that is at least 5 x 10⁻⁵ m wide, an average of 50 µm (= L) wide in Example 2, from the outer edge 114 of the land portions 14A and 14B. That is, in Example 2, the edge portions of the extending portions 21 of the solder mask 20, which extending portions are covering the land portions 14A and 14B, have a circular form having a diameter of 1.25 mm.

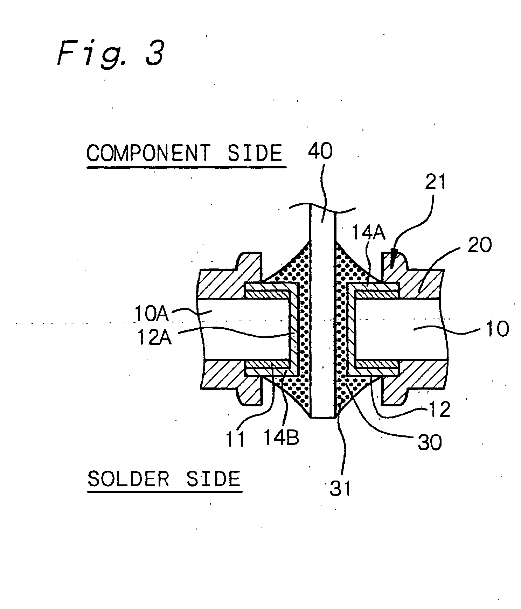

In Example 2, a lead-free solder containing Sn-3.0Ag-0.5Cu as a main component and a lead-free solder containing Sn-0.7Cu as a main component were used, and a component-attaching portion (component-lead-portion 40) of a lead-portion-attached component having an Sn-10Pb plated layer formed on a brass surface was inserted into the through-hole portion 13 from the component side through the land portion 14, and then, the component-attaching portion (component-lead-portion 40) was fixed to the through-hole portion 13 and the land portions 14A and 14B with the lead-free solder using a solder iron, whereby the component was mounted on the printed wiring board. Fig. 3 schematically shows this state.

As Comparative Example 2, printed wiring boards were manufactured in the same manner as in Example 2 except that an average of 75 µm clearance CL was provided between the outer edge 114 of each land portion 14A and 14B and the end portion of the solder mask 20, that is, except that each of the land portions 14A and 14B had a plan form that was a circle having a diameter of 1.35 mm and that the end portion of the solder mask 20 had a form that was a circle having a diameter of 1.5 mm. Components were mounted on the land portions in the same manner as in Example 2.

The thus-obtained printed wiring boards were evaluated in the same manner as in Example 1. In Example 2, no breaking of wire occurred in the printed wiring boards. In Comparative Example 2, about 17.5 % of the printed wiring boards had breaking of wire. The above results show that the occurrence of the lift-off phenomenon and the land peeling phenomenon can be remarkably prevented by employing the land portion of a printed wiring board, the method of manufacturing a printed wiring board and the component mounting method for a printed wiring board according to the second and third aspects of the present invention.

### Example 3

Example 3 is a variant of Example 2. In Example 3, the land portions 14A and 14B had a square plan form whose sides were 1.35 mm long each. Further, the edge portion of the extending portions 21 of the solder mask 20 for covering the land portions 14A and 14B had a circular form having a diameter of 1.25 mm. Components were mounted on the land portions in the same manner as in Example 2. As Comparative Example 3, printed wiring boards were manufactured in the same manner as in Example 3 except that an average of 75 µm clearance CL was provided between the outer edge 114 of each land portion 14A and 14B and the end portion of the solder mask 20, that is, except that the end portion of the solder mask 20 had a square form whose sides were 1.5 mm long each, and components were mounted on the land portions in the same manner as in Example 3. As a result, in Example 3, no breaking of wire occurred in the printed wiring boards. In Comparative Example 3, about 20 % of the printed wiring boards had breaking of wire.

### Example 4

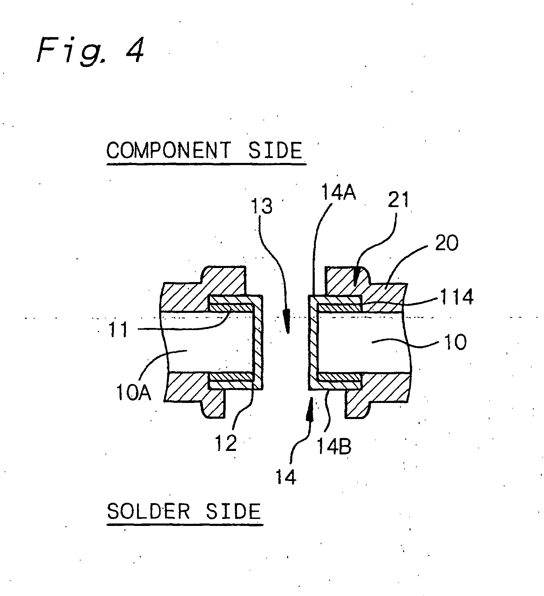

Example 4 is also a variant of Example 2. In Example 4, as shown in the schematic partial end view of Fig. 4, the area of the land portion 14A extending on the component side, which area was not covered with the extending portion 21 of the solder mask 20, was small than the area of the land portion 14B extending on the solder side, which area was not covered with the extending, portion 21 of the solder mask 20.

Specifically, in Example 4, the land portions 14A and 14B had a circular plan form having a diameter of 1.35 mm. The edge portion of the extending portion 21 of the solder mask 20 covering the land portion 14A extending on the component side had a circular form having a diameter of 1.1 mm, and the edge portion of the extending portion 21 of the solder mask 20 covering the land portion 14B extending on the solder side had a circular form having a diameter of 1.25 mm. Components were mounted on the land portions in the same manner as in Example 2. As a result, in Example 4, no breaking of wire occurred in the thus-manufactured printed wiring boards.

Further, the land portions 14A and 14B were formed so as to have a square plan form whose sides were 1.35 mm long each. The edge portion of the extending portion 21 of the solder mask 20 covering the land portion 14A extending on the component side had a circular form having a diameter of 1.1 mm, and the edge portion of the extending portion 21 of the solder mask 20 covering the land portion 14B extending on the solder side had a circular form having a diameter of 1.25 mm. Components were mounted on the land portions in the same manner as in Example 2. As a result, similarly, no breaking of wire occurred in the thus-manufactured printed wiring boards.

### Example 5

Example 5 is a variant of Example 2 as well. In Example 5, the land portions 14A and 14B had a circular plan form having a diameter of 1.5 to 2.25 mm. In this case, the circumferential portions of the land portions 14A and 14B are covered with the extending portions 21 of the solder mask 20 formed on the component side and on the solder side of the printed wiring board, such that the circumferential portions have a covered area that is at least 5 x 10⁻⁵ m wide, an average of 75 µm (= L) wide in Example 5, from the outer edges 114 of the land portions 14A and 14B. That is, in Example 5, the edge portions of the extending portions 21 of the solder masks 20 covering the land portions 14A and 14B had a circular form having a diameter of 1.35 to 2.1 mm.

In Example 5, a lead-free solder containing Sn-2.5%Ag-1%Bi-0.5%Cu as a main component was used, and the component-attaching portion (component-lead-portion) of the lead-portion-attached component having an Sn-10Pb plated layer formed thereon was inserted into the through-hole portion 13 through the land 14, and then, the component-attaching portion (component-lead-portion) was fixed to the through-hole portion 13 and the land portions 14A and 14B with the lead-free solder according to a flow soldering method of a double wave type, whereby the component was mounted on the printed wiring board.

As Comparative Example 4, printed wiring boards were manufactured in the same manner as in Example 5 except that an average of 75 µm clearance CL was provided between the outer edges 114 of the land portions 14A and 14B and the end portions of the solder masks 20, that is, except that the land portions 14A and 14B were formed so as to have a circular plan form having a diameter of 1.5 to 2.25 mm, and that the end portion of each solder mask had a circular form having a diameter of 1.65 to 2.4 may, and components were mounted on the land portions in the same manner as in Example 5.

After component mounting, it was studied whether or not a lift-off phenomenon and a land peeling phenomenon took place on each of the land portions of the printed wiring boards. A printed wiring board having the lift-off phenomenon or the land peeling phenomenon even at one portion was taken as being defective. Tables 1 and 2 show the results. In Example 5 and Comparative Example 4, 100 printed wiring boards were inspected each.

**Table 1**

| [Land peeling phenomenon] | | |
|---|---|---|
| | Example 5 | Comparative Example 4 |
| Component side | 0 % | 19 % |
| Solder side | 0% | 29% |

**Table 2**

| [Lift-off phenomenon] | | |
|---|---|---|
| | Example 5 | Comparative Example 4 |
| Component side | 24 % | 55 % |
| Solder side | 0 % | 1% |

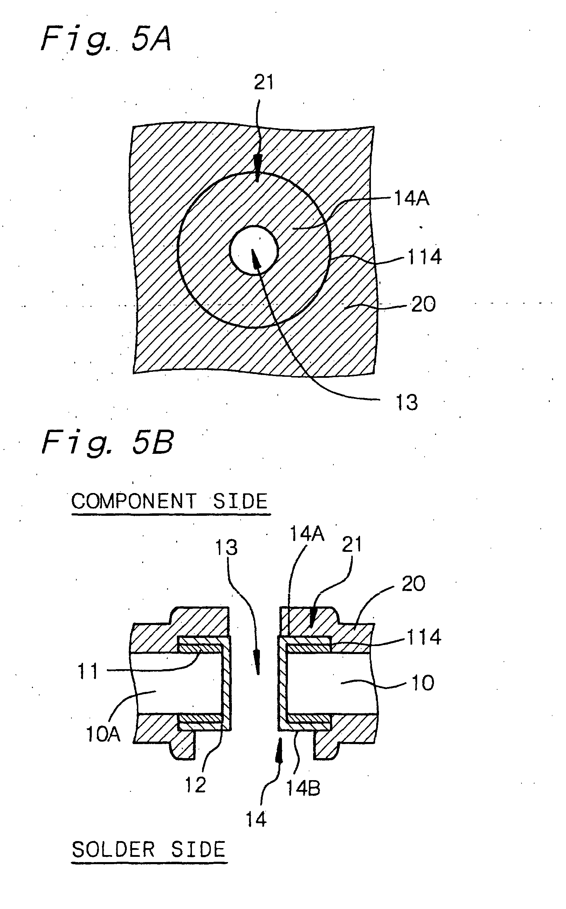

The present invention has been explained with reference to preferred embodiments above, while the present invention shall not be limited thereto. The constitutions and production conditions of the printed wiring boards and component mounting methods and conditions explained in Examples, and the lead-free solder, the lead-free cream solder and components used in Examples are given for illustrative purposes and can be modified as required. A positional relationship between a land portion and a solder mask is schematically shown in the partial plan view of Fig. 5A and the partial end view of Fig. 5B. An almost entire land portion 14A extending on the component side may be covered with an extending portion 21 of a solder mask 20. Further, while a conventional leaded solder is used, if a condition of use of a printed wiring-board on which components are mounted is severe, a land portion may be peeled from the surface of a base material. In such a case, even if a conventional leaded solder is used, it is preferred to apply the land portion of a printed wiring board, the method of manufacturing method of a printed wiring board or the component mounting method for a printed wiring board according to the present invention.

In the present invention, the occurrence of the land peeling phenomenon and the lift-off phenomenon can be suppressed or prevented. As a result, there is no breaking of wire caused by these phenomena, so that printed wiring boards printed wiring boards on which components are mounted can be remarkably improved in reliability.

## Claims

1. A land portion of a printed wiring board, formed on a surface of the printed wiring board for mounting a component with a lead-free solder,
wherein a circumferential portion of said land portion is covered with an extending portion of a solder mask formed on the surface of the printed wiring board, and
the circumferential portion of said land portion is covered with the extending portion of the solder mask, such that the circumferential portion has a covered area that is at least 5 x 10⁻⁵ m wide from the outer edge of the land portion.

2. Land portions of a printed wiring board, extending on a component side and on a solder side of the printed wiring board from a through-hole portion made through the printed wiring board, for mounting a component with a lead-free solder,
wherein a circumferential portion of the land portion extending on the component side is covered with an extending portion of a solder mask formed on the component side of the printed wiring board, and
the circumferential portion of the land portion extending on the component side is covered with an extending portion of the solder mask formed on the component side of the printed wiring board, such that the circumferential portion has a covered area that is at least 5 x 10⁻⁵ m wide from the outer edge of the land portion.

3. Land portions of a printed wiring board, extending on a component side and on a solder side of the printed wiring board from a through-hole portion made through the printed wiring board, for mounting a component with a lead-free solder,
wherein a circumferential portion of the land portion extending on the component side is covered with an extending portion of a solder mask formed on the component side of the printed wiring board, and
a circumferential portion of the land portion extending on the solder side is covered with an extending portion of the solder mask formed on the solder side of the printed wiring board.

4. The land portions of a printed wiring board according to claim 3, wherein the circumferential portion of the land portion extending on the component side is covered with the extending portion of the solder mask formed on the component side such that the circumferential portion has a covered area that is at least 5 x 10⁻⁵ m wide from the outer edge of the land portion, and
the circumferential portion of the land portion extending on the solder side is covered with the extending portion of the solder mask formed on the solder side of the printed wiring board such that the circumferential portion has a covered area that is at least 5 x 10⁻⁵ m wide from the outer edge of the land portion.

5. The land portions of a printed wiring board according to claim 3, wherein the area of the land portion extending on the component side, which area is not covered with the extending portion of the solder mask, is smaller than the area of the land portion extending on the solder side, which area is not covered with the extending portion of the solder mask.

6. A method of manufacturing a printed wiring board comprising the steps of;
(A) forming a wiring and a land portion on a surface of a base material for printed wirings, and
(B) forming a solder mask on the surface of the base material for printed wirings, to obtain a printed wiring board,
wherein the step (B) includes the step of covering a circumferential portion of the land portion with an extending portion of the solder mask formed on the base material for printed wirings, such that the circumferential portion has a covered area that is at least 5 x 10⁻⁵ m wide from the outer edge of the land portion.

7. A method of manufacturing a printed wiring board comprising the steps of;
(A) forming a through-hole portion through a base material for printed and wirings, and forming land portions extending on a component side and on a solder side of the base material for printed wirings from said through-hole portion, and a wiring on the base material for printed wirings, and
(B) forming a solder mask on the component side and the solder side of the base material for printed wirings, to obtain a printed wiring board,
wherein the step (B) includes the step of covering a circumferential portion of the land portion extending on the component side with an extending portion of the solder mask formed on the component side of the base material for printed wirings, such that the circumferential portion has a covered area that is at least 5 x 10⁻⁵ m wide from the outer edge of the land portion.

8. A method of manufacturing a printed wiring board comprising the steps of;
(A) forming a through-hole portion through a base material for printed wirings, and forming land portions extending on a component side and on a solder side of the base material for printed wirings from said through-hole portion, and a wiring on the base material for printed wirings, and
(B) forming a solder mask on the component side and the solder side of the base material for printed wirings, to obtain a printed wiring board,
wherein the step (B) includes the step of covering a circumferential portion of the land portion extending on the component side with an extending portion of the solder mask formed on the component side of the base material for printed wirings and the step of covering a circumferential portion of the land portion extending on the solder side with an extending portion of the solder mask formed on the solder side of the printed wiring board.

9. The method of manufacturing a printed wiring board according to claim 8, wherein, in the above step (B), the circumferential portion of the land portion extending on the component side is covered with the extending portion of the solder mask formed on the component side of the printed wiring board, such that the circumferential portion has a covered area that is at least 5 x 10⁻⁵ m wide from the outer edge of the land portion, and the circumferential portion of the land portion extending on the solder side is covered with the extending portion of the solder mask formed on the solder side of the printed wiring board, such that the circumferential portion has a covered area that is at least 5 x 10⁻⁵ m wide from the outer edge of the land portion.

10. The method of manufacturing a printed wiring board according to claim 8, wherein the area of the land portion extending on the component side, which area is not covered with the extending portion of the solder mask, is smaller than the area of the land portion extending on the solder side, which area is not covered with the extending portion of the solder mask.

11. A component mounting method for a printed wiring board comprising the steps of;
(A) forming a wiring and a land portion on a surface of a base material for printed wirings,
(B) forming a solder mask on the surface of the base material for printed wirings, to obtain a printed wiring board, and
(C) fixing a component-attaching portion to the land portion with a lead-free solder, to mount a component on the printed wiring board,
wherein the step (B) includes the step of covering a circumferential portion of the land portion with an extending portion of the solder mask formed on the base material for printed wirings, such that the circumferential portion has a covered area that is at least 5 x 10⁻⁵ m wide from the outer edge of the land portion.

12. A component mounting method for a printed wiring board comprising the steps of;
(A) forming a through-hole portion through a base material for printed wirings, and forming land portions extending on a component side and on a solder side of the base material for printed wirings from said through-hole portion, and a wiring on the base material for printed wirings,
(B) forming a solder mask on the component side and the solder side of the base material for printed wirings, to obtain a printed wiring board, and
(C) inserting a component-attaching portion into the through-hole portion and fixing the component-attaching portion to the through-hole portion and the land portion with a lead-free solder, to mount a component on the printed wiring board,
wherein the step (B) includes the step of covering a circumferential portion of the land portion extending on the component side with an extending portion of the solder mask formed on the component side of the base material for printed wirings, such that the circumferential portion has a covered area that is at least 5 x 10⁻⁵ m wide from the outer edge of the land portion.

13. A component mounting method for a printed wiring board comprising the steps of;
(A) forming a through-hole portion through a base material for printed wirings, and forming land portions extending on a component side and on a spider side of the base material for printed wirings from said through-hole portion, and a wiring on the base material for printed wirings,
(B) forming a solder mask on the component side and the solder side of the base material for printed wirings, to obtain a printed wiring board, and
(C) inserting a component-attaching portion into the through-hole portion and fixing the component-attaching portion to the through-hole portion and the land portion with a lead-free solder, to mount a component on the printed wiring board,
wherein the step (B) includes the step of covering a circumferential portion of the land portion extending on the component side with an extending portion of the solder mask formed on the component side of the base material for printed wirings and the step of covering a circumferential portion of the land portion extending on the solder side with an extending portion of the solder mask formed on the solder side of the printed wiring board.

14. The component mounting method for a printed wiring board according to claim 13, wherein, in the above step (B), the circumferential portion of the land portion extending on the component side is covered with the extending portion of the solder mask formed on the component side of the printed wiring board, such that the circumferential portion has a covered area that is at least 5 x 10⁻⁵ m wide from the outer edge of the land portion, and the circumferential portion of the land portion extending on the solder side is covered with the extending portion of the solder mask formed on the solder side of the printed wiring board, such that the circumferential portion has a covered area that is at least 5 x 10⁻⁵ m wide from the outer edge of the land portion.

15. The component mounting method for a printed wiring board according to claim 13, wherein the area of the land portion extending on the component side, which area is not covered with the extending portion of the solder mask, is smaller than the area of the land portion extending on the solder side, which area is not covered with the extending portion of the solder mask.
